# EUROPEAN PATENT APPLICATION

(11) **EP 2 107 614 A2**
(43) Date of publication of application: **07.10.2009**
(21) Application number: 09155611.8
(22) Date of filing: 19.03.2009
(51) Int. Cl.: H01L 31/0216, H01L 27/142, H01L 31/052, H01L 31/20

(54) **Thin-film photovoltaic cell, thin-film photovoltaic module and method of manufacturing thin-film photovoltaic cell**

(30) Priority: 01.04.2008 KR 20080030342
(71) Applicant: KISCO Corporation, Changwon-si Gyeongsangnam-do 641-370 (KR)
(72) Inventor: Myong, Seung-Yeop, 156-831, Seoul (KR)
(74) Representative: Zambardino, Umberto

(57) **Abstract**

A method of manufacturing a thin-film photovoltaic cell, comprises laminating a transparent electrode on a transparent substrate, laminating a photovoltaic layer on the transparent electrode, laminating a metal electrode layer on the photovoltaic layer and laminating a buffer layer on the metal electrode layer, the buffer layer being made of a moisture resistance material.

## Description

### BACKGROUND

### 1. Field

This embodiment relates to a thin-film photovoltaic cell, a thin-film photovoltaic module and method for manufacturing thin-film photovoltaic cell.

### 2. Description of the Related Art

Silicon, compound or organic thin-film photovoltaic cells are weaker for moisture than bulk photovoltaic cells under a high-temperature and high-humidity environment. Therefore, conversion efficiency is lowered, and long-term reliability is degraded.

In case of the silicon or compound thin-film photovoltaic cell, moisture is easily absorbed by zinc oxide (ZnO) or silver (Ag) used as a back contact on its surface or grain boundary at a high temperature. In this case, a fill factor (FF) is decreased due to an increase of resistance, and therefore, conversion efficiency is lowered.

In case of the organic thin-film photovoltaic cell, an organic matter itself as well as a back contact is very weak for moisture, and therefore, the lifetime of the photovoltaic cell is extremely shortened. A damp heat test is specified as a required item in the photovoltaic module certification system. The damp heat test estimates whether or not efficiency is maintained constant for over 1000 hours under the condition including a temperature of 85°C and a humidity of 85%.

Accordingly, to secure long-term reliability, an encapsulation of the thin-film photovoltaic cell is very important to prevent moisture from being penetrated into the photovoltaic cell.

### SUMMARY

In one aspect, a method of manufacturing a thin-film photovoltaic cell, comprises laminating a transparent electrode on a transparent substrate, laminating a photovoltaic layer on the transparent electrode, laminating a metal electrode layer on the photovoltaic layer and laminating a buffer layer on the metal electrode layer, the buffer layer being made of a moisture resistance material.

The method further comprises forming an isolation trench from a surface of the buffer layer to a surface of the transparent electrode using laser.

The method further comprises laminating a rear reflective layer comprising zinc oxide between the photovoltaic layer and the metal electrode layer.

The rear reflective layer may be laminated using a metal-organic chemical vapor deposition (MOCVD) method or a low pressure chemical vapor deposition (LPCVD) method.

The rear reflective layer may have a thickness of 50 nm to 2500 nm.

The buffer layer may have a thickness of 50 nm to 1000 nm.

The moisture resistance material may comprise indium tin oxide (ITO), tin oxide (Sn02) or indium zinc oxide (IZO).

The buffer layer may be doped with an impurity.

In other aspect, a thin-film photovoltaic cell comprises a transparent electrode laminated on a transparent substrate, a photovoltaic layer laminated on the transparent electrode, a metal electrode layer laminated on the photovoltaic layer and a buffer layer laminated on the metal electrode layer, and the buffer layer comprises a moisture resistance material.

The buffer layer may have a thickness of 50 nm to 1000nm.

The moisture resistance material may comprise indium tin oxide (ITO), tin oxide (Sn02) or indium zinc oxide (IZO).

The thin-film photovoltaic cell may further comprise a rear reflective layer comprising zinc oxide (ZnO) between the photovoltaic layer and the metal electrode layer.

The rear reflective layer may have a thickness of 50 to 2500nm.

The buffer layer may be doped with an impurity.

### BRIEF DESCRIPTION OF THE DRAWINGS

The accompanying drawings, which are included to provide a further understanding of the embodiments and are incorporated on and constitute a part of this specification, illustrate the embodiments and together with the description serve to explain the principles of the embodiments. In the drawings:

FIG. 1 is a cross-sectional view illustrating the structure of a thin-film photovoltaic cell according to an embodiment.

FIG. 2 illustrates a method of manufacturing the thin-film photovoltaic cell according to an embodiment.

FIG. 3 is a flowchart illustrating a method of manufacturing a thin-film photovoltaic module according to an embodiment.

### DETAILED DESCRIPTION OF EMBODIMENTS

Reference will now be made in detail embodiments of which are illustrated in the accompanying drawings.

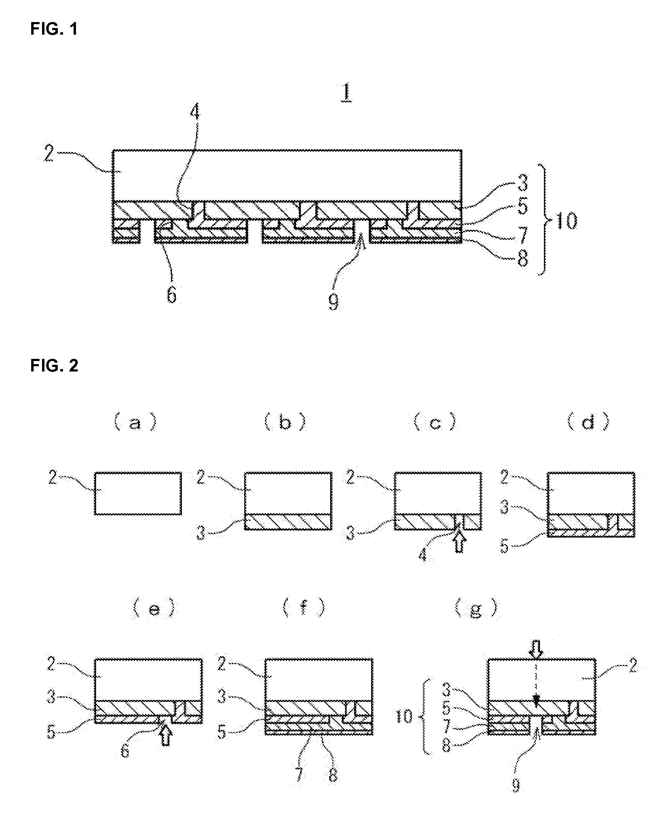

As illustrated in FIG. 1, a thin-film photovoltaic cell 1 comprises a plurality of unit cells 10 formed on a transparent substrate 2 such as a glass substrate or transparent plastic substrate. The plurality of unit cells 10 are electrically connected in series to one another.

The unit cell 10 comprises a transparent electrode 3 on the transparent substrate 2 that is an insulator, a photovoltaic layer 5 covering the transparent electrode 3, a metal electrode layer 7 covering the photovoltaic layer 5, and a buffer layer 8 covering the metal electrode layer 7. At this time, the transparent electrode 3 and the metal electrode layer 7 are connected to each other, and hence, the plurality of unit cells 10 are electrically connected in series to one another.

The transparent electrode 3 is formed on the transparent substrate 2 using a chemical vapor deposition (CVD) method or a sputtering method. The transparent electrode 3 may be made of indium tin oxide (ITO), tin oxide (SnO₂), zinc oxide (ZnO) or the like.

The photovoltaic layer 5 converts light incident from the outside of the photovoltaic cell 1 into electricity. In case of an amorphous silicon photovoltaic cell, the photovoltaic layer 5 may comprise a p-layer, an i-layer and an n-layer, sequentially laminated from a side onto which sunlight is incident. The p-layer, the i-layer and the n-layer may be amorphous silicon-based thin-films. The p-layer is a thin-film doped with an impurity such as a group III element, and the i-layer is a thin-film in which no impurity is substantially contained. The n-layer is a thin-film doped with an impurity such as a group V element.

The metal electrode layer 7 serves as an electrode of the unit cell 10, and reflects light transmitting the photovoltaic layer 5. The metal electrode layer 7 is formed using a film forming method such as a CVD or sputtering method.

In case of a silicon or compound thin-film photovoltaic cell, moisture is easily absorbed by zinc oxide (ZnO) or silver (Ag) used as the metal electrode layer 7 on its surface or grain boundary at a high temperature. In case of an organic thin-film photovoltaic cell, an organic matter itself as well as the metal electrode layer 7 is very weak for moisture.

To maximize a light trapping effect, before the metal electrode layer 7 is formed, a metal electrode layer made of zinc oxide (ZnO) is formed using a CVD method through which natural irregularities are formed. In the metal electrode layer formed using the CVD method, moisture is easily absorbed by the zinc oxide (ZnO) on its grain boundary, and oxygen is trapped in an oxygen vacancy of the zinc oxide (ZnO), so that resistance may be easily increased.

Accordingly, in the first embodiment, a buffer layer 8 is formed on the metal electrode layer 7 so as to improve moisture resistance. The buffer layer 8 includes indium tin oxide (ITO), tin oxide (SnO₂) or indium zinc oxide (IZO), and has a thickness of 50 nm to 1000 nm.

If the thickness of the buffer layer 8 is in a range of 50 nm to 1000 nm, the buffer layer 8 improves moisture resistance while recovering electrical characteristics of the metal electrode layer 7, thereby enhancing characteristics of the photovoltaic cell. That is, if the thickness of the buffer layer 8 is 50nm or thicker, it is possible to effectively prevent moisture. If the thickness of the buffer layer 8 is 1000nm or thinner, it is possible to prevent excessive consumption of a raw material or time required in deposition using the sputtering method. Accordingly, it is possible to prevent cost for producing photovoltaic cells from being increased.

As illustrated in (a) of FIG. 2, a transparent substrate 2 is prepared, and a transparent electrode 3 is laminated on the transparent substrate 2 so as to cover the transparent substrate 2. The transparent electrode 3 is formed of tin oxide (SnO₂) or zinc oxide (ZnO) using a CVD method.

As illustrated in (b) and (c) of FIG. 2, laser is irradiated from a side of the transparent electrode 3 or a side of the insulative transparent substrate 2 in the atmosphere, and the laser is absorbed into the transparent electrode 3. Accordingly, the transparent electrode 3 is scribed, and a first isolation trench 4 passing through the transparent electrode 3 is formed in the transparent electrode 3. The first isolation trench 4 prevents a short circuit of the transparent electrode 3 between the unit cells 10.

As illustrated in (d) of FIG. 2, a photovoltaic layer 5 is laminated on the transparent electrode 3 so as to cover the transparent electrode 3 and the first isolation trench 4. As described above, the photovoltaic layer 5 comprises a p-layer, an i-layer and an n-layer, sequentially laminated using a CVD method.

As illustrated in (e) of FIG. 2, laser is irradiated from a side of the insulative transparent substrate 2 or a side of the photovoltaic layer 5 in the atmosphere. Accordingly, the laser is absorbed into the photovoltaic layer 5, and the photovoltaic layer 5 is scribed. Therefore, a second isolation trench 6 is formed in the photovoltaic layer 5. That is, the second isolation trench 6 passes through the photovoltaic layer 5.

As illustrated in (f) of FIG. 2, a metal electrode layer 7 is laminated to cover the photovoltaic layer 5 and the second isolation trench 6. The metal electrode layer 7 comprises zinc oxide (ZnO) or silver (Ag) using a CVD or sputtering method.

Further, as illustrated in (f) of FIG. 2, a buffer layer 8 is formed on the metal electrode layer 7 so as to improve moisture resistance. The buffer layer 8 includes indium tin oxide (ITO), tin oxide (SnO₂) or indium zinc oxide (IZO), and has a thickness of 50 nm to 1000nm.

As illustrated in (g) of FIG. 2, laser is irradiated from a side of the transparent substrate 2 in the atmosphere. The laser irradiated from the side of the transparent substrate 2 scribes the photovoltaic layer 5, the metal electrode layer 7 and the buffer layer 8. Accordingly, a third isolation trench 9 passes through the photovoltaic layer 5, the metal electrode layer 7 and the buffer layer 8. The distance between the third and first isolation trenches 9 and 4 may be greater than that between the third and second isolation trenches 9 and 6. Accordingly, area of the photovoltaic layer 5, which converts light into electricity, increases.

A thin-film photovoltaic cell is manufactured by the aforementioned method.

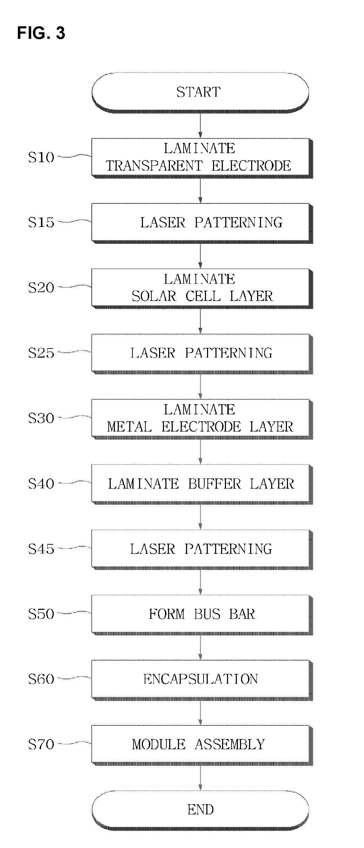

As illustrated in FIG. 3, a method of manufacturing a thin-film photovoltaic module according to an embodiment comprises laminating a transparent electrode on a transparent substrate (S10); forming a pattern on the transparent electrode using laser (S15) and laminating a photovoltaic layer that converts light into electricity on the transparent electrode (S20); forming a pattern adjacent to the pattern of the transparent electrode on the photovoltaic layer using laser(S25) and laminating a metal electrode layer on the photovoltaic layer(S30); laminating a buffer layer comprising a moisture resistance material to a thickness of 50 nm to 1000nm on the metal electrode layer using a sputtering method (S40); encapsulating the transparent electrode, the photovoltaic layer, the metal electrode layer and the buffer layer (S60). The moisture resistance material may be indium tin oxide (ITO), tin oxide (SnO₂), or indium zinc oxide (IZO).

In the embodiment illustrated in FIG. 3, a rear reflective layer comprising zinc oxide (ZnO) may be formed between the metal electrode layer and the photovoltaic layer using a CVD method such as a metal-organic chemical vapor deposition (MOCVD) method or a low pressure chemical vapor deposition (LPCVD) method before the laminating of the metal electrode layer (S30).

When the rear reflective layer made of zinc oxide (ZnO) is formed using a CVD method such as an MOCVD or LPCVD method, irregularities are naturally formed on the rear reflective layer, thereby maximizing the light trapping effect. The rear reflective layer may have a thickness of 50 nm to 2500 nm. If the thickness of the rear reflective layer is in the range of 50 nm to 2500 nm, the light trapping effect can be maintained by the refractive index matching while photoelectric conversion is stably performed.

After the laminating of the buffer layer, an isolation trench is formed to complete a serial connection between unit cells using a laser scribing equipment (S45). The isolation trench passes through a surface of the buffer layer to a surface of the transparent electrode. Accordingly, when the buffer layer is laminated, the isolation trench passing through the surface of the buffer layer to the surface of the transparent electrode can be formed.

The buffer layer comprising an anti-moisture material may be doped with an impurity so as to have high conductivity. When the conductivity is increased, the buffer layer shares the functions of the metal electrode layer. For this reason, the thickness of the metal electrode layer comprising a material such as zinc oxide (ZnO) or silver (Ag) is decreased, and accordingly, a unit cost for production can be lowered.

To protect the photovoltaic cell from an external environment, the photovoltaic cell is encapsulated with a material having electrical insulating properties while allowing light to be transmitted therein (S60). A thin-film photovoltaic module is manufactured by forming a bus bar (S50) before the encapsulation (S60) and by performing module assembly (S70) after the encapsulation (S60).

In the encapsulation (S60), the photovoltaic cell is encapsulated and sealed with an encapsulating member and a sealing member. The encapsulating member may comprise an ethylene vinyl acetate (EVA) film and a low iron content tempered glass. That is, the encapsulation (S60) comprises encapsulating and laminating the photovoltaic cell with the EVA film having excellent moisture resistance and the low iron content tempered glass; sealing edge portions of the photovoltaic cell with the sealing member.

A back sheet having a TPT structure may be used rather than the low iron content tempered glass. In the TPT structure, a poly-vinyl fluoride (PVF) film, a poly-ethylene terephthalate (PET) film and a poly-vinyl fluoride (PVF) film are sequentially laminated into a sandwich structure. Alternatively, a back sheet having a TPT structure may be used rather than the low iron content tempered glass. In the TPT structure, a poly-vinylidene fluoride (PVDF) film, a poly-ethylene terephthalate (PET) film and a poly-vinylidene fluoride (PVDF) film are sequentially laminated.

The photovoltaic cell may be encapsulated by a back sheet having an aluminum (Al) foil interposed between the films constituting the TPT structure. Accordingly, a unit cost for producing modules can be decreased.

Thereafter, an outer frame made of aluminum or the like is fixed to increase strength of the entire module, thereby completing the module.

## Claims

1. A method of manufacturing a thin-film photovoltaic cell, comprising:
laminating a transparent electrode (3) on a transparent substrate (2);
laminating a photovoltaic layer (5) on the transparent electrode;
laminating a metal electrode layer (7) on the photovoltaic layer; and
laminating a buffer layer (8) on the metal electrode layer, the buffer layer being made of a moisture resistance material.

2. The method according to claim 1, further comprising forming an isolation trench from a surface of the buffer layer to a surface of the transparent electrode using laser.

3. The method according to claim 1, further comprising laminating a rear reflective layer comprising zinc oxide between the photovoltaic layer and the metal electrode layer.

4. The method according to claim 3, wherein the rear reflective layer is laminated using a metal-organic chemical vapor deposition (MOCVD) method or a low pressure chemical vapor deposition (LPCVD) method.

5. The method according to claim 3, wherein the rear reflective layer has a thickness of 50 nm to 2500 nm.

6. The method according to claim 1, wherein the buffer layer has a thickness of 50 nm to 1000 nm.

7. The method according to claim 1, wherein the moisture resistance material comprises indium tin oxide (ITO), tin oxide (SnO₂) or indium zinc oxide (IZO).

8. The method according to claim 1, wherein the buffer layer is doped with an impurity.

9. A thin-film photovoltaic cell, comprising:
a transparent electrode (3) laminated on a transparent substrate (2);
a photovoltaic layer (5) laminated on the transparent electrode;
a metal electrode layer (7) laminated on the photovoltaic layer; and
a buffer layer (8) laminated on the metal electrode layer, the buffer layer comprising a moisture resistance material.

10. The thin-film photovoltaic cell according to claim 9, wherein the buffer layer has a thickness of 50 nm to 1000nm.

11. The thin-film photovoltaic cell according to claim 9, wherein the moisture resistance material comprises indium tin oxide (ITO), tin oxide (SnO₂) or indium zinc oxide (IZO).

12. The thin-film photovoltaic cell according to claim 9, further comprising a rear reflective layer comprising zinc oxide (ZnO) between the photovoltaic layer and the metal electrode layer.

13. The thin-film photovoltaic cell according to claim 12, wherein the rear reflective layer has a thickness of 50 to 2500nm.

14. The thin-film photovoltaic cell according to claim 9, wherein the buffer layer is doped with an impurity.
